# EUROPÄISCHE PATENTSCHRIFT

(11) **EP 0 859 468 B1**
(45) Veröffentlichungstag und Bekanntmachung des Hinweises auf die Patenterteilung: **17.11.2004**
(21) Anmeldenummer: 98101517.5
(22) Anmeldetag: 29.01.1998
(51) Int. Cl.: H03K 17/96

(54) **Schaltungsanordnung für ein Sensorelement**
Circuitry for a sensor element
Circuit pour un élément capteur

(30) Priorität: 17.02.1997 DE 19706167; 29.11.1997 DE 29721213 U
(43) Veröffentlichungstag der Anmeldung: 19.08.1998
(73) Patentinhaber: E.G.O. ELEKTRO-GERÄTEBAU GmbH, 75038 Oberderdingen (DE)
(72) Erfinder: Götz, Bernhard, 75059 Zaisenhausen (DE); Russ, Ivo, 75038 Oberderdingen-Flehingen (DE)
(74) Vertreter: Patentanwälte Ruff, Wilhelm, Beier, Dauster & Partner

(56) Entgegenhaltungen:
- EP-A- 0 675 600
- DE-A- 3 119 495
- US-A- 5 189 417
- US-A- 5 270 710

## Beschreibung

### Anwendungsgebiet und Stand der Technik

Die Erfindung betrifft eine Schaltungsanordnung für wenigstens ein Sensorelement wenigstens eines Berührungsschalters, bei der ein Ansteuersignal an dem Sensorelement anliegt und abhängig vom Betätigungszustand des Sensorelements veränderbar ist, wobei das Ansteuersignal frequenzmoduliert ist.

In vielen elektrischen Geräten werden heutzutage Berührungsschalter eingesetzt, vor allem auch in Haushaltsgeräten. Durch einfaches Antippen des Schalters, der meistens eine Metalloberfläche aufweist, kann vom Benutzer ein gewünschter Schaltvorgang ausgelöst werden.

Bei bekannten Berührungsschaltern, die ein Sensorelement aufweisen, ist eine Beschaltung vorgesehen, die an das Sensorelement eine meist hochfrequente Wechselspannung anlegt, die bei Betätigung des Berührungsschalters verändert wird. Diese Veränderung wird detektiert und löst ein Schaltsignal aus. Dabei gibt es jedoch erhebliche Probleme mit Störungen, die das Signal störend überlagern. Diese Störungen rühren zum einen von der Spannungsversorgung aus dem Netz her, da durch die zunehmende Anzahl elektrischer Geräte der sogenannte Elektrosmog stark zugenommen hat, was bedeutet, daß der Netzspannung zahlreiche Störsignale überlagert sind. Genauso strahlen andere Geräte, vor allem im Haushalt, wie Fernseher, Computer aber auch Mobiltelefone, Störsignale ab, die alle zusammen auch über den Benutzer das Signal am Sensorelement störend überlagern.

Aus diesem Grund wurde schon versucht, durch eine Erhöhung der angelegten Signalspannung von 5 V (übliche Versorgungsspannung elektronischer Schaltungen) auf 20 bis 30 V ein stärkeres Signal zu erzeugen, das gegen Störungen unempfindlich ist. Das bedeutet zum einen die Notwendigkeit einer zweiten Spannungsversorgung, zum anderen konnten aber auch dadurch die Probleme nicht vollständig gelöst werden.

Die EP 675 600 offenbart in einer Schaltungsanordnung gemäß dem Oberbegriff des Anspruchs 1 einen reflektierenden Berührungsschalter auf Ultraschallbasis, bei dem die Berührung charakterisierende Reflexion eines Signals durch ein piezoelektrisches Element detektiert wird. Gleichzeitig sendet dieses piezoelektrische Element das Ansteuersignal aus. Das Ansteuersignal ist dabei durch das piezoelektrische Element amplitudenmoduliert. Zur Detektion einer Auslösung des Schalters wird das empfangene Signal demoduliert.

Die US-A-5 270 710 zeigt eine Ansteuerschaltung für einen Schalter, der dadurch betätigt wird, dass zwei Kontakte durch eine zusammendrückbare elektrisch leitfähige Hülle miteinander verbunden werden. Ein Ansteuersignal liegt dabei an einem Kontakt an. Der andere Kontakt liegt über einen Kondensator und eine Diode an einer Auswerteschaltung an. Negative Halbwellen des an einem Kontakt anliegenden Ansteuersignals werden durch eine Diode jeweils automatisch für diese Halbwelle an Masse geschlossen.

### Aufgabe und Lösung

Aufgabe der Erfindung ist es, eine verbesserte Schaltungsanordnung für ein Sensorelement eines Berührungsschalters zu schaffen, die gegen Störsignale unanfällig ist und insbesondere ohne zusätzliche Spannungsversorgung auskommt.

Diese Aufgabe wird gelöst durch die Merkmale des Anspruchs 1. Insbesondere kann dies die Nullspannung sein. Bevorzugt wird die Nullphase des Ansteuersignals auf Null gelegt. Dadurch werden Störsignale, die in dieser Phase auftreten und sich bei einer Überlagerung der Nullphase besonders störend bemerkbar machen, auf einfache Weise unterdrückt. Das Signal wird also zumindest teilweise bereinigt.

Das Ansteuersignal durchläuft bevorzugt periodisch einen bestimmten Frequenzbereich, wodurch Störsignale, die jeweils eine bestimmte feste Frequenz aufweisen, nur sehr kurz synchron zum Ansteuersignal auftreten. Dadurch, daß die Auswertung so ausgeführt sein kann, daß sie nur über einen längeren Zeitraum bzw. einen gewissen Frequenzbereich auftretende Veränderungen des Signalpegels als Schaltzustandsveränderungen erkennt, spielen Störsignale mit einer anderen bzw. einer festen Frequenz keine Rolle. Außerdem treten Störsignale meistens nur in bestimmten Frequenzbereichen auf, und beim Durchlaufen eines weiten, viel größeren Frequenzbereichs werden diese Bereiche nur kurz überdeckt.

Die Schaltungsanordnung besteht aus wenigstens einem Ansteuer-, einem Sensor- und einem Auswerteteil, wobei insbesondere jedes Sensorelement einen zugehörigen Sensorteil, vorzugsweise eine Sensorschaltung, aufweist. Durch diese Aufteilung ist es möglich, mehrere Berührungsschalter mit nur einem Ansteuer- und einem Auswerteteil zu kombinieren. Bei voller Funktion kann man die Anzahl der Bauteile und damit den Aufwand und die Fehleranfälligkeit senken.

Bevorzugt kann eine im Ansteuerteil erzeugte Arbeitsfrequenz mit einem festen Frequenzhub u.U. periodisch veränderbar zwischen einem Minimalwert und einem Maximalwert liegen, wobei insbesondere der Minimalwert ca. 5 kHz und der Maximalwert ca. 50 kHz betragen können. Die Modulationsfrequenz kann vorteilhaft etwa 20 bis 1000 Hz betragen. Durch den weiten Frequenzbereich von 5 kHz bis 50 kHz wird sichergestellt, daß ausreichend Bereiche durchlaufen werden, in denen keine Störsignale vorhanden sind. Vor allem niederfrequente Störungen, beispielsweise Oberschwingungen der Netzfrequenz, werden so ausgeschlossen. Die feste Modulationsfrequenz sorgt dafür, daß der Frequenzbereich ausreichend schnell durchlaufen wird. Der Aufwand für diese Frequenzerzeugung ist unwesentlich größer als für eine feste Ausgangsfrequenz.

Besonders bevorzugt ist das Ansteuersignal als Rechtecksignal, insbesondere als Rechtecksignal mit einem Tastverhältnis von etwa 70 % bis 95 % und/oder einem Signalpegel von etwa 5 V, ausgebildet. Das hohe Tastverhältnis sorgt dafür, daß die Dauer des Nullpegels nicht zu groß ist, so daß die am Schluß entstehende Gleichspannung ausreichend hoch ist. Durch die Verwendung eines Signalpegels von 5 V kann man die für die elektronischen Bauelemente verwendete Betriebsspannung benutzen und braucht keine weitere Spannungsversorgung. Damit reduziert sich der Aufwand, die Betriebssicherheit wird erhöht und Störeinflüsse von einer weiteren Spannungsversorgung werden vermieden.

Vorteilhaft bildet ein Bauelement, insbesondere ein Speisekondensator, einen Teil eines Spannungsteilers, insbesondere eines kapazitiven Spannungsteilers, wobei das Sensorelement den anderen bzw. zweiten Teil des Spannungsteilers bildet. Der Berührungsschalter ist über die Fingerkapazität des Benutzers betätigbar, und deswegen bietet sich ein kapazitiver Spannungsteiler an. Mit einem derartigen Spannungsteiler kann auf sehr einfache Weise durch Überwachung der Teilspannungen eine Veränderung einer der beiden Kapazitäten, in diesem Fall der Kapazität des Sensors, detektiert werden. Der Speisekondensator weist bevorzugt eine konstant bleibende Kapazität auf.

Um die Ansteuerung mehrerer Sensorteile mit einem einzigen Ansteuerteil zu ermöglichen, ist das Bauelement, das den ersten Teil des Spannungsteilers bildet, in dem Sensorteil enthalten. Über Abzweigleitungen, die von einem Speiseknoten abgehen, sind die Sensorteile an den Ansteuerteil anschließbar, so daß an allen Sensorteilen dasselbe Ansteuersignal anliegt.

Bevorzugt ist dem Ausgang des Sensorteils ein Filter, insbesondere ein R-C-Filter, vorgeschaltet. Durch diesen Filter wird das Signal des Sensorelements in eine Gleichspannung umgewandelt, die vom Tastverhältnis, dem Signalpegel und dem Betätigungszustand des Berührungsschalters abhängt. Da die beiden ersten Größen fest sind, kann durch eine Auswertung der Gleichspannung ein Betätigen des Berührungsschalters detektiert werden. Solch ein Filter ist ohne großen Aufwand aufzubauen und die entstandene Gleichspannung ist mit einfachen Mitteln auszuwerten. Vorteilhaft ist in jedem Sensorteil ein Filter vorgesehen um Störungen zu vermeiden.

Bei einer Ausführung der Erfindung können die Schaltmittel einen Schalter enthalten, insbesondere einen Schalter mit einem Halbleiterbauelement. Das Halbleiterbauelement kann beispielsweise ein Transistor sein oder ein anderes, schnell reagierendes Bauelement.

Nach einer weiteren Ausführungsmöglichkeit der Erfindung weist der Ansteuerteil eine Frequenzgenerator zur Erzeugung des frequenzmodulierten Ansteuersignals mit der Arbeitsfrequenz auf. Der Aufwand für einen solchen Frequenzgenerator ist nicht wesentlich größer als für einen mit einer festen Arbeitsfrequenz, da derartige Frequenzgeneratoren in anderen Anwendungsgebieten üblich sind.

Wenn zur Ansteuerung des Schalters zwei invertierende Bauelemente hintereinander an einer beliebigen Stelle im Signalpfad hinter dem Frequenzgenerator und vor dem Sensorelement, beispielsweise vor einem Speisekondensator, vorgesehen sind, wobei das einfach invertierte Signal am Ausgang des ersten invertierenden Bauelements zu dem Schalter geführt ist und dessen Ansteuerung bildet, ist eine automatische Ankoppelung des Schalters und seiner Funktion an die Arbeitsfrequenz gewährleistet. Durch die Serienschaltung zweier Inverter erhält man am Ausgang des zweiten wieder das unveränderte Ansteuersignal. Die Inverter arbeiten schnell und zuverlässig und stellen keine Fehlerquelle dar.

Zur Auswertung mehrerer Signale weist der Auswerteteil an seinem Eingang einen Signal-Multiplexer mit wenigstens einem Eingang zum Anschluß wenigstens eines Ausgangs eines Sensorteils und einem Ausgang auf, an dem über einen Signalverstärker eine Signalauswerteeinheit, insbesondere ein Mikrokontroller, angeschlossen ist. So braucht man nur eine Signalauswerteeinheit für alle verwendeten Sensorelemente und der Aufwand wird reduziert.

Nach einer Ausführungsmöglichkeit der Erfindung kann die Schaltungsanordnung wenigstens einen Mikrokontroller enthalten, der unter anderem für die Erzeugung des Ansteuersignals mit der Arbeitsfrequenz für wenigstens ein Sensorelement eingerichtet ist. Eine derartige softwaremäßige Erzeugung stellt ein beliebig variables Ansteuersignal zur Verfügung, wodurch ein weiter Bereich von Anwendungen ermöglicht wird. Auf diese Weise kann ein zusätzlicher Frequenzgenerator eingespart werden, was Kosten spart und die Störanfälligkeit senkt. Der Mikrokontroller ist vorteilhaft für weitere Zwecke außer der Frequenzerzeugung einsetzbar, so für die Auswertung des Sensorsignals oder ganz andere Steuerungsaufgaben in einem zu dem Berührungsschalter gehörenden Gerät.

Bevorzugt enthält ein Mikrokontroller bei einer Ausführung Ansteuerteil und Auswerteteil der Schaltungsanordnung. Das reduziert den Aufwand weiter und ermöglicht eine genaue Auswertung des am Sensorelement anliegenden Signals. Vorteilhaft können dabei auch die Schaltmittel in dem Mikrokontroller enthalten sein, die für das Kurzschließen jeweils einer Phase des am Sensorelement anliegenden Ansteuersignals an eine konstante Spannung, vorzugsweise die Nullspannung, ausgebildet sind. Dadurch wird die Anzahl der benötigten Bauteile auf ein Minimum reduziert, was sich auch auf die Fehleranfälligkeit positiv auswirkt. Als Meßmethode bietet sich eine AD-Messung an, wobei die AD-Wandlung durch Dualslope-Verfahren, Singleslope-Verfahren (mit einem Komparator im Mikrokontroller) oder durch einen eigenen AD-Wandler erfolgen kann. Dieser ist vorzugsweise in dem Mikrokontroller enthalten. Bevorzugt wird jedoch die AD-Wandlung durch Dualslope-Verfahren angewandt.

Eine besonders günstige Ausführung der Erfindung sieht vor, daß das Sensorelement ein in sich flexibler, raumformveränderlicher und elektrisch leitfähiger Körper ist und insbesondere für den Einsatz in einem Berührungsschalter eines Hartglas- oder Glaskeramikkochfeldes vorgesehen ist. Bevorzugt handelt es sich um einen elektrisch leitfähigen Schaumstoff. Die Verwendung eines derartigen Sensorelements für diesen Zweck bietet eine Reihe von Vorteilen. Das Sensorelement kann Materialeigenschaften aufweisen, die das Auftreten von Störeinflüssen unterdrücken helfen.

Vorteilhaft kann der Körper des Sensorelements wenigstens einen Durchbruch in Richtung der Berührungsflächen aufweisen, in dem insbesondere ein durch ein Hartglas- oder Glaskeramikkochfeld sichtbares Beleuchtungselement enthalten ist. Dies kann beispielsweise eine LED sein, mit der die genaue Position der Berührungstaste anzeigbar ist.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen dargestellt und wird im folgenden näher erläutert. In den Zeichnungen zeigen:
- Fig. 1: eine Schaltungsanordnung, bestehend aus Ansteuer-, Sensor- und Auswerteteil, mit einem an einem Glaskeramikkochfeld angebrachten Sensorelement,
- Fig. 2: die Schaltungsanordnung mit einem Mikrokontroller, der Ansteuer- und Auswerteteil enthält,
- Fig. 3 bis 5: ein üblicherweise verwendetes Sensorelement zum Einbau an ein Glaskeramikkochfeld und
- Fig. 6 bis 8: ein neuartiges Sensorelement nach einem Merkmal der Erfindung zum Einbau an ein Glaskeramikkochfeld.

### Beschreibung eines bevorzugten Ausführungsbeispiels

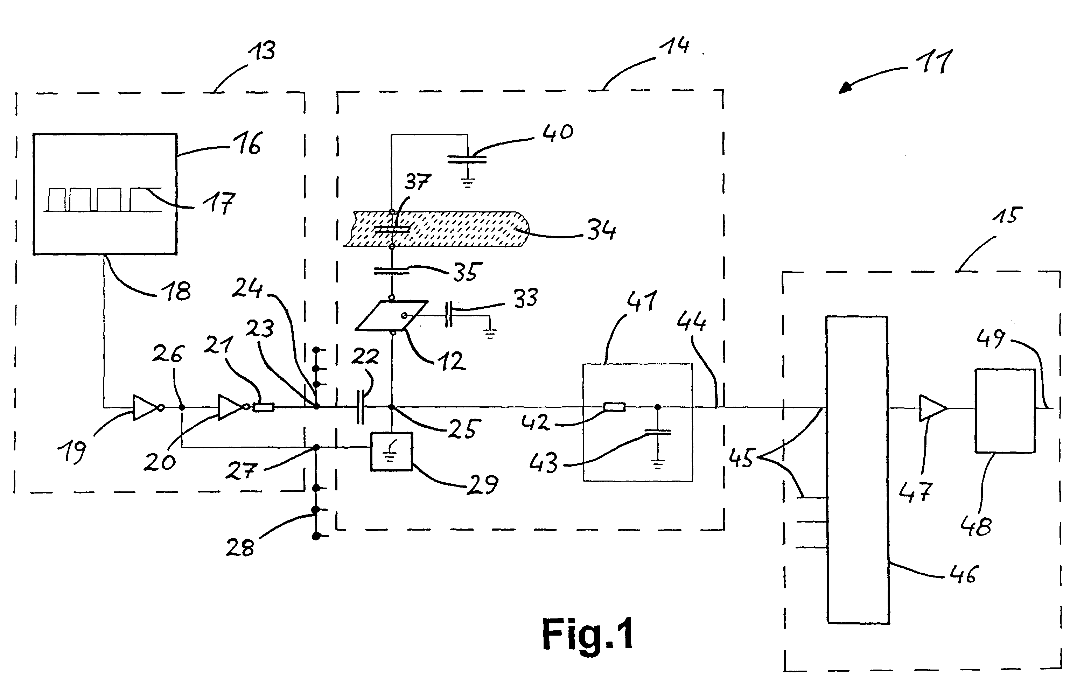

Die Fig. 1 zeigt eine Schaltungsanordnung 11 für ein Sensorelement 12, die aus einem Ansteuerteil 13, einem Sensorteil 14 und einem Auswerteteil 15 besteht. Der Ansteuerteil 13 enthält einen Frequenzgenerator 16, der ein Ansteuersignal 17 mit einer Arbeitsfrequenz erzeugt, das an einem Ausgang 18 des Frequenzgenerators 16 ausgegeben wird und aus einem frequenzmodulierten Rechtecksignal besteht. Es wird zu einem ersten Inverter 19 geführt und von dort zu einem zweiten Inverter 20. Danach geht es über einen Speisewiderstand 21 an einen Speiseknoten 23, von dem eine erste Abzweigleitung 24 abgeht, an die eine Anzahl von Sensorteilen 14 angeschlossen sein können, von denen jedoch nur einer dargestellt ist. Von der ersten Abzweigleitung 24 geht eine Verbindung über einen Speisekondensator 22 zu einem Signalknoten 25 in dem Sensorteil 14 ab.

Hinter dem ersten Inverter 19 befindet sich ein Abzweig 26, der zu einem Schalterknoten 27 führt. Von dem Schalterknoten 27 geht eine zweite Abzweigleitung 28 ab, an die eine Vielzahl von Schaltern 29 angeschlossen werden können. Jeder Sensorteil 14 enthält einen Schalter 29, der an seinem einen Schaltanschluß mit dem Signalknoten 25 und an seinem anderen Schaltanschluß mit dem Nullpegel der Schaltungsanordnung 11 verbunden ist, der auf Masse liegt.

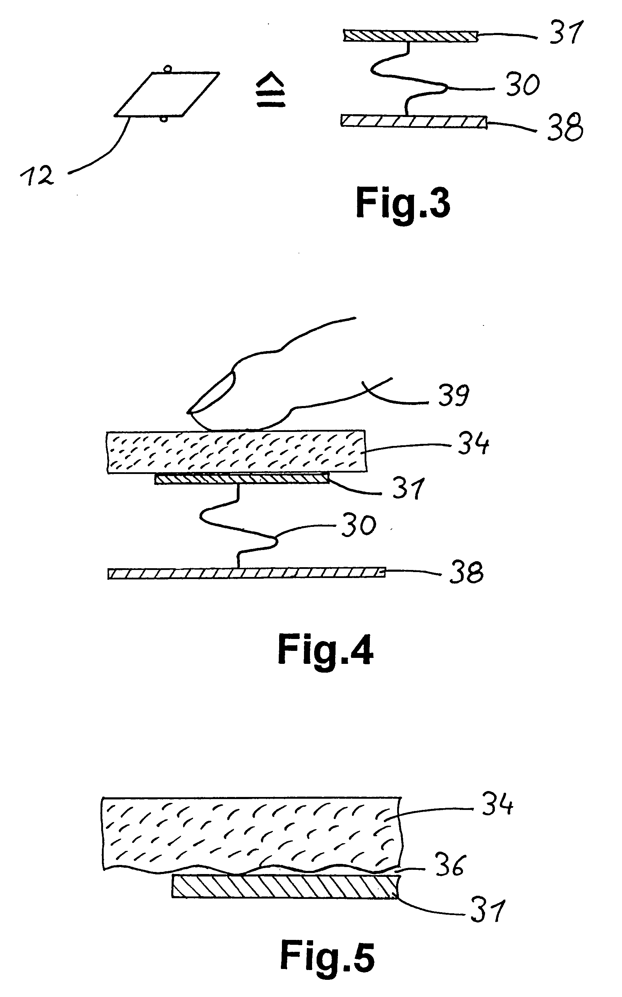

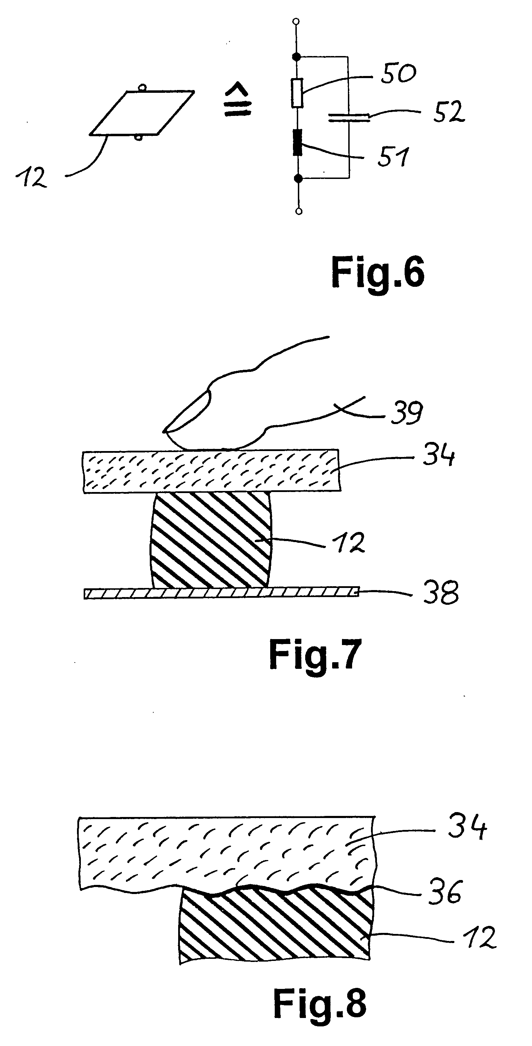

Vom Signalknoten 25 geht eine Verbindung zum Anschluß des Sensorelements 12, wobei der Anschluß durch eine Leiterplatte 38 erfolgt, auf der das Sensorelement 12 sitzt, siehe Fig. 4 oder 7. Der Aufbau des Sensorelements 12 kann aus Fig. 3 entnommen werden. Von der Leiterplatte 38 geht ein Federelement 30, das leitfähig sein muß und vorzugsweise als metallische Feder ausgebildet ist, nach oben ab und trägt eine Sensorleitplatte 31, die von dem Federelement 30 gegen ein Hartglas- oder Glaskeramikkochfeld 34 gedrückt wird. Das Sensorelement 12 weist eine Streukapazität 33 auf, die gegen Masse geht.

Durch die mechanische Ankoppelung des Sensorelements 12 an das Glaskeramikkochfeld 34 entsteht eine Luftspaltkapazität 35, da die Ankoppelung durch eine herstellungsbedingte Noppung 32 auf der Unterseite des Glaskeramikkochfeldes 34 mit einem Luftspalt 36 versehen ist. Dies wird in Fig. 5 in Vergrößerung gezeigt.

Die Kapazität des Glaskeramikkochfeldes 34 wird durch eine Glaskapazität 37 dargestellt. In Fig. 4 sieht man einen Finger 39, der das Glaskeramikkochfeld 34 oberhalb des Sensorelements 12 berührt. Dadurch kommt zur Glaskapazität 37 eine serielle Fingerkapazität 40 hinzu, die gegen Masse geht.

Vom Signalknoten 25 geht eine Verbindung zu einem Filter 41, der als R-C-Filter aus einem seriellen Filterwiderstand 42 und einem Filterkondensator 43, der gegen Masse geht, besteht. Vom Filter 41 geht eine Verbindung an einen Ausgang 44 des Sensorteils 14.

Dieser Ausgang 44 des Sensorteils 14 geht an einen von mehreren Eingängen 45 eines Signalmultiplexers 46. Der Signalmultiplexer 46 ist über einen Signalverstärker 47 an eine Signalauswerteeinheit, insbesondere einen Mikrokontroller 48 angeschlossen. Diese drei Bauteile bilden den Auswerteteil 15, an den so viele Sensorteile 14 angeschlossen werden können, wie der Signalmultiplexer Eingänge aufweist. Der Mikrokontroller ist mit einem Ausgang 49 an einen nicht dargestellten Teil einer Schaltung angeschlossen, die die vom Mikrokontroller erzeugten Befehle umsetzt, beispielsweise für eine Leistungsab- oder zuschaltung eines Elektroherdes.

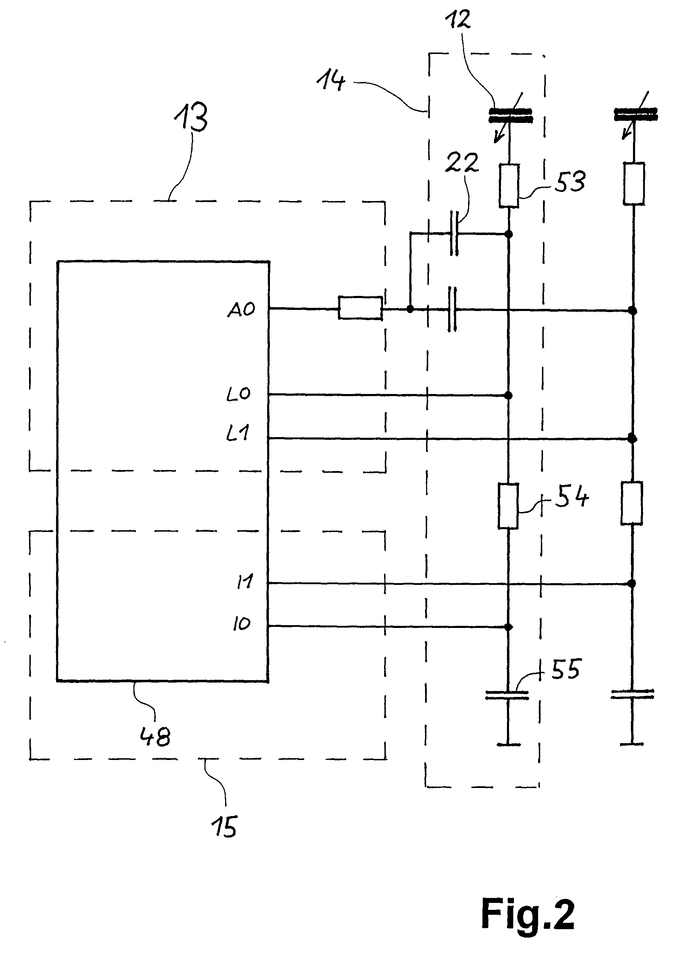

In der Fig. 2 wird ein Ausführungsbeispiel mit Erzeugung des Ansteuersignals in dem Mikrokontroller 48 dargestellt. Das Ansteuersignal 17 wird über den Anschluß A0, einen gemeinsamen Vorwiderstand und jeweils einzelne Speisekondensatoren 22 und Widerstände 53 an das Sensorelement 12 gegeben. In dieser Zeichnung ist das Sensorelement 12 als veränderlicher Kondensator dargestellt, wobei die Veränderung der Kapazität durch Berührung des Berührungsschalters erfolgt. Gleichzeitig sind über die Widerstände 53 die Sensorelemente 12 mit weiteren Widerständen 54 und Kondensatoren 55 gegen Masse gelegt.

Die Anschlüsse L0 und L1 dienen jeweils zum Entladen der Kondensatoren 55, die mit den Widerständen 54 ein RC-Glied bilden. Die Auswertung des an einem Sensorelement 12 anliegenden Ansteuersignals 17 erfolgt über Verbindungen der Anschlüsse I0 und I1 an die Kondensatoren 55 des RC-Gliedes.

Wie dargestellt, vereinigt der Mikrokontroller 48 sowohl den Ansteuerteil 13 als auch den Auswerteteil 15. Der Sensorteil 14 wird von den Sensorelementen 12 sowie den Speisekondensatoren 22, den Widerständen 53 und 54 sowie den Kondensatoren 55 gebildet. Je nach Art des verwendeten Mikrokontrollers 48 kann eine verschieden große Anzahl von Sensorteilen 14 bzw. Sensorelementen 12 betrieben werden.

Ein Ersatzschaltbild eines aus einem elektrisch leitfähigen und flexiblen Schaumstoff bestehenden Sensorelements 12 ist in Fig. 6 zu sehen. Es kann durch eine Parallelschaltung aus einem Ersatzwiderstand 50 mit einem seriellen induktiven Widerstand 51 und einer Parallelkapazität 52 dargestellt werden.

In Fig. 7 ist ein zwischen Leiterplatte 38 und Glaskeramikkochfeld 34 angebrachtes Sensorelement 12 dargestellt, das aus einem elektrisch leitfähigen und flexiblen Schaumstoff besteht. In Fig. 8 kann man erkennen, daß sich das Sensorelement 12 so gut an die genoppte Unterseite des Glaskeramikkochfeldes 34 anpaßt, daß das Entstehen eines Luftspaltes 36 vermieden wird.

### Funktion

An dieser Stelle wird zuerst auf die Ausführung mit Frequenzgenerator eingegangen. Die Schaltung wird gemäß dem Schaltplan aus Fig. 1 aufgebaut, vorzugsweise in SMD-Technik und auf der Leiterplatte 38, die auch die Abstützung und gleichzeitig den Anschluß für das Sensorelement 12 bildet. Die Verwendung eines Signalpegels von 5 V hat den großen Vorteil, daß nur eine Spannungsversorgung mit 5 V benötigt wird, da dies die Betriebsspannung des Signalmultiplexers 46 und des Mikrokontrollers 48 ist.

Der Frequenzgenerator 16 erzeugt erst ein Rechtecksignal mit einem Signalpegel von 5 V, einem Tastverhältnis von etwa 70 bis 95 % und einer Frequenz von 20 bis 500 kHz. Dieses Rechtecksignal wird mit einer Modulationsfrequenz von 20 bis 1000 Hz frequenzmoduliert, und zwar zwischen Eckwerten von typischerweise 5 bis 50 kHz. Dadurch erhält man das Ansteuersignal 17.

Der erste Inverter 19 wird zur Ansteuerung des Schalters 29 benötigt. Wenn das Ansteuersignal 17 auf Null zurückgeht, so wird es vom Inverter 19 invertiert und auf 5 V gesetzt, und durch dieses Hochsetzen wird der Schalter 29 aktiviert und schließt den Signalknoten 25 gegen Masse. Somit ist das am Signalknoten 25 liegende Signal immer dann Null, wenn das Ansteuersignal 17 Null ist. Störungen werden so während dieser Zeit unterdrückt. Durch den zweiten Inverter 20 hinter dem ersten wird wieder das ursprüngliche Ausgangssignal 17 hergestellt. Dieses geht über den Speisewiderstand 21 und die Abzweigleitung 24 an den Speisekondensator 22.

Im unbetätigten Zustand weist das Sensorelement 12 nur seine Streukapazität 33 auf, die mit dem Speisekondensator 22 einen Spannungsteiler für das am Speisekondensator anliegende Ausgangssignal bildet. Dabei kann der Speisekondensator 22 so dimensioniert sein, daß am Sensorelement 12 die halbe Spannung anliegt, also die Speisekapazität ungefähr so groß ist wie die Streukapazität 33. Bei Betätigung des Berührungsschalters kommen parallel zur Streukapazität 33 noch die Luftspaltkapazität 35, die Glaskapazität 37 und die Fingerkapazität 40, die seriell geschaltet sind, hinzu. Durch diese Parallelschaltung wird die Gesamtkapazität des Sensorelements 12 größer, das Teilerverhältnis der Gesamtkapazität zur Kapazität des Speisekondensators 22 verändert sich, und die Spannung am Sensorelement und damit am Signalknoten 25 nimmt ab. Am Ausgang des an den Signalknoten 25 angeschlossenen Filters 41 stellt sich eine Gleichspannung ein, die nur vom vorgegebenen Signalpegel, dem Tastverhältnis, das bekannt und unveränderlich ist, und von der Sensorspannung, die vom Betätigungszustand des Berührungsschalters abhängig ist, abhängt.

Diese Gleichspannung wird an einen Signalmultiplexer 46 gegeben, der eine von mehreren Gleichspannungen mehrerer Sensorschaltungen 14 auswählt und diese über einen Signalverstärker 47 auf einen Mikrokontroller 48 gibt. Der Mikrokontroller 48 wertet die Gleichspannung aus und detektiert, ob der Berührungsschalter betätigt wurde oder nicht. Dabei ist die Auswertung vorzugsweise so ausgelegt, daß über einen gewissen Zeitraum, entsprechend einem in diesem Zeitraum überstrichenem Frequenzbereich, hinweg beispielsweise aufsummierend oder integrierend ausgewertet wird. Erst wenn also eine Veränderung der Gleichspannung über diesen gewissen Zeitraum hinweg stattfindet soll die Auswertung eine Betätigung melden. Tritt nun ein Störsignal mit einer festen Frequenz auf, so ändert sich die Gleichspannung wenn überhaupt nur für einen Moment, und das fällt innerhalb des für die Auswertung vorgesehenen Zeitraumes nicht ins Gewicht. Von einer Detektierung abhängig gibt der Mikrokontroller an seinem Ausgang 49 Befehle an eine weitere Schaltung aus, beispielsweise die Steuerschaltung für eine Kochfeldbeheizung.

Der Ersatzwiderstand 50 bildet mit dem Speisekondensator 22 und der Streukapazität 33 einen Filter, der die Einkoppelung von Störsignalen über den Finger 39 bei der Betätigung des Berührungsschalters dämpft. Um das Material des Sensorelements 12 leitfähig zu machen, können verschiedene Materialien, z.B. Graphit, Silber o.dgl. beigemischt werden. Wenn man statt dessen oder zusätzlich ferritische Materialien beimischt, entsteht der induktive Widerstand 51, der eine weitere Verbesserung der Dämpfung von Störsignalen bewirkt. Besonders vorteilhaft ist ein in der gleichzeitig eingereichten europäischen Patentanmeldung EP 859 467 mit dem Titel "Berührungsschalter mit Sensortaste" gezeigtes und beschriebenes Sensorelement. Auf diese Weise kann mit einem derartigen Sensorelement eine besonders günstige Ausführung der Erfindung geschaffen werden. Sie kann gleichermaßen bei beiden Versionen der Erzeugung des Ansteuersignals eingesetzt werden.

Die Ausführung nach der Fig. 2 steuert das Sensorelement 12 nach folgendem Schema an:

Im ersten Schritt wird das RC-Glied aus dem Widerstand 54 und dem Kondensator 55 über den Anschluß L0 entladen. Im zweiten Schritt wird der Kondensator 55 über den Anschluß L0 so lange aufgeladen, bis am Eingang I0 ein logischer High-Pegel gemessen wird. Dies ist in der Praxis dann gegeben, wenn der Kondensator 55 auf die allgemeine Betriebsspannung von 5 Volt aufgeladen ist.

Im Schritt 3 wird am Anschluß A0 für eine bestimmte Zeit das Ansteuersignal 17 mit der erfindungsgemäßen Modulation bzw. Frequenzmodulation erzeugt und damit der Kondensator 55 über den Widerstand 54 entladen. Das Ansteuersignal kann im wesentlichen dem der Ausführung mit Frequenzgenerator gleichen. In dieser Phase wird der Anschluß L0 vor jedem Wechsel des Signals von Low nach High an A0 hochohmig und vor dem Wechsel von High nach Low an A0 niederohmig gegen die Nullspannung geschaltet. Auf diese Weise erfolgt bei dieser Ausführung das Masselegen während der Nullphase des Ansteuersignals.

Im Schritt 4 wird das RC-Glied aus Widerstand 54 und Kondensator 55 über den Anschluß L0 wieder aufgeladen. Dabei wird die Zeit gemessen, bis das Signal am Anschluß I0 auf den High-Pegel wechselt. Wie oben angesprochen, erfolgt die AD-Wandelung des an dem Anschluß I0 bzw. I1 anliegenden Signals vorzugsweise im Dualslope-Verfahren. Die Auswertung der an dem Sensorelement anliegenden Spannung kann bevorzugt dynamisch erfolgen, wodurch eine Temperaturdrift des Signalpegels ausgeglichen werden kann.

Ebenso wie bei dem Ausführungsbeispiel nach Fig. 1 wird hier die Veränderung des Ansteuersignals 17 durch Berührung des damit gespeisten Sensorelements 12 erreicht. Ein daraus resultierender Schaltvorgang kann genau gleich erfolgen.

## Patentansprüche

1. Schaltungsanordnung für wenigstens ein Sensorelement (12) wenigstens eines Berührungsschalters, bei der ein Ansteuersignal (17) mit einer Arbeitsfrequenz an dem Sensorelement anliegt und abhängig vom Betätigungszustand des Sensorelements veränderbar ist, wobei das Ansteuersignal ein frequenzmoduliertes Ansteuersignal ist, **gekennzeichnet durch** Schaltmittel (29), die für das Kurzschließen jeweils einer Phase des am Sensorelement (12) anliegenden Ansteuersignals (17) an eine konstante Spannung ausgebildet sind.

2. Schaltungsanordnung nach Anspruch 1, **dadurch gekennzeichnet, daß** die Schaltungsanordnung (11) aus wenigstens einem Ansteuer- (13), einem Sensor- (14) und einem Auswerteteil (15) besteht, wobei insbesondere jedes Sensorelement (12) einen zugehörigen Sensorteil (14) aufweist.

3. Schaltungsanordnung nach Anspruch 1 oder 2, **dadurch gekennzeichnet, daß** die Arbeitsfrequenz mit einem festen Frequenzhub periodisch veränderbar zwischen einem Minimalwert und einem Maximalwert liegt.

4. Schaltungsanordnung nach einem der vorhergehenden Ansprüche, **dadurch gekennzeichnet, daß** das Ansteuersignal (17) ein Rechtecksignal ist, insbesondere ein Rechtecksignal mit einem Tastverhältnis von etwa 70 % bis 95 % und einem Signalpegel von etwa 5 V.

5. Schaltungsanordnung nach einem der vorhergehenden Ansprüche, **dadurch gekennzeichnet, daß** ein Bauelement (22) einen ersten Teil eines Spannungsteilers bildet und das Sensorelement (12) den zweiten Teil des Spannungsteilers bildet, wobei insbesondere das Bauelement (22), das den ersten Teil des Spannungsteilers bildet, in dem Sensorteil (14) enthalten ist.

6. Schaltungsanordnung nach einem der vorhergehenden Ansprüche, **dadurch gekennzeichnet, daß** die Schaltmittel für das Kurzschließen jeweils einer Phase des am Sensorelement (12) anliegenden Ansteuersignals (17) an die Nullspannung ausgebildet sind, wobei die Schaltmittel vorzugsweise einen Schalter (29), insbesondere einen Schalter mit einem Halbleiterbauelement, enthalten.

7. Schaltungsanordnung nach einem der vorhergehenden Ansprüche, **gekennzeichnet durch** einen Frequenzgenerator (16) zur Erzeugung des frequenzmodulierten Ansteuersignals (17) mit der Arbeitsfrequenz, wobei vorzugsweise zur Ansteuerung der Schaltmittel (29) zwei invertierende Bauelemente (19, 20) hintereinander an einer beliebigen Stelle im Signalpfad hinter dem Frequenzgenerator (16) und vor dem Sensorelement (12) vorgesehen sind und wobei das nach dem ersten invertierenden Bauelement (19) einfach invertierte Signal am Ausgang dieses Bauelements (19) zu den Schaltmitteln (29) geführt ist und deren Ansteuerung bildet.

8. Schaltungsanordnung nach Anspruch 2, **gekennzeichnet durch** einen Signal-Multiplexer (46) mit wenigstens einem Eingang (45) zum Anschluß wenigstens eines Ausgangs (44) eines Sensorteils (14) und mit einem Ausgang, an dem über einen Signalverstärker (47) eine Signalauswerteeinheit (48) angeschlossen ist, wobei insbesondere der Signal-Multiplexer (46) in dem Auswerteteil (15) enthalten ist.

9. Schaltungsanordnung nach einem der Ansprüche 1 bis 6, **gekennzeichnet durch** wenigstens einen Mikrokontroller (48), der für die Erzeugung mindestens des Ansteuersignals (17) mit der Arbeitsfrequenz für wenigstens ein Sensorelement (12) ausgebildet ist, wobei er insbesondere den Ansteuerteil (13) und/oder den Auswerteteil (15) und die Schaltmittel (29) enthält.

10. Schaltungsanordnung nach einem der vorhergehenden Ansprüche, **dadurch gekennzeichnet, daß** das Sensorelement (12) ein in sich flexibler, raumformveränderlicher und elektrisch leitfähiger Körper ist, vorzugsweise aus elektrisch leitfähigem Schaumstoff besteht, wobei es insbesondere für den Einsatz in einem Berührungsschalter eines Hartglas- oder Glaskeramikkochfeldes (34) vorgesehen ist.

## Claims

1. Circuit arrangement for at least one sensor element (12) of at least one contact switch in which a control signal (17) is applied to the sensor element with a working frequency and is variable depending on the actuation state of the sensor element, where the control signal is a frequency-modulated control signal, **characterized by** switching means (29) which are designed for short-circuiting one phase each of the control signal (17) applied to the sensor element (12) to a constant voltage.

2. Circuit arrangement according to Claim 1, **characterized in that** the circuit arrangement (11) comprises at least one control part (13), one sensor part (14) and one evaluation part (15), where in particular each sensor element (12) has an associated sensor part (14).

3. Circuit arrangement according to Claim 1 or Claim 2, **characterized in that** the working frequency with a fixed frequency deviation is periodically variable between a minimum and a maximum value.

4. Circuit arrangement according to one of the preceding claims, **characterized in that** the control signal (17) is a rectangular signal, in particular a rectangular signal, with a duty factor of around 70 % to 95 % and a signal level of around 5 V.

5. Circuit arrangement according to one of the preceding claims, **characterized in that** a component (22) forms a first part of a voltage divider and the sensor element (12) the second part of the voltage divider, where in particular the component (22) forming the first part of the voltage divider is contained in the sensor part (14).

6. Circuit arrangement according to one of the preceding claims, **characterized in that** the switching means are designed for short-circuiting one phase each of the control signal (17) applied to the sensor element (12) to the zero voltage, where the switching means contain preferably one switch (29), in particular a switch with a semiconductor component.

7. Circuit arrangement according to one of the preceding claims, **characterized by** a frequency generator (16) for generating the frequency-modulated control signal (17) with the working frequency, where for control of the switching means (29) two inverting components (19, 20) are preferably provided one behind the other at any point in the signal path behind the frequency generator (16) and in front of the sensor element (12), and where the signal inverted once after the first inverting component (19) is passed at the output of this component (19) to the switching means (29) and provides their control.

8. Circuit arrangement according to Claim 2, **characterized by** a signal multiplexer (46) with at least one input (45) for connection of at least one output (44) of a sensor part (14) and with an output to which a signal evaluation unit (48) is connected via a signal amplifier (47), where in particular the signal multiplexer (46) is contained in the evaluation part (15).

9. Circuit arrangement according to one of Claims 1 to 6, **characterized by** at least one micro-controller (48) which is designed for the generation of at least the control signal (17) with the working frequency for at least one sensor element (12), where said micro-controller contains in particular the control part (13) and/or the evaluation part (15) and the switching means (29).

10. Circuit arrangement according to one of the preceding claims, **characterized in that** the sensor element (12) is a per se flexible, shape-variable and electrically conductive element, preferably comprising electrically conductive foam material, intended in particular for use in a contact switch of a hard glass or glass ceramic hob (34).

## Revendications

1. Circuit pour au moins un élément capteur (12) d'au moins un commutateur tactile dans lequel est appliqué à l'élément capteur, avec une fréquence de travail, un signal de commande (17) qui est variable en fonction de l'état d'actionnement de l'élément capteur, sachant que le signal de commande est un signal de commande à fréquences modulées,
**caractérisé par** des dispositifs de commutation (29) qui sont conçus pour le court-circuitage d'une phase du signal de commande (17) appliqué à l'élément capteur (12) à une tension constante.

2. Circuit selon la revendication 1, **caractérisé en ce que** le circuit (11 ) est composé d'au moins une unité de commande (13), une unité de captage (14) et une unité d'analyse (15), sachant en particulier que chaque élément capteur (12) présente une unité de captage (14) correspondante.

3. Circuit selon la revendication 1 ou 2, **caractérisé en ce que** la fréquence de travail est, avec une déviation fixe de fréquences, périodiquement variable entre une valeur minimale et une valeur maximale.

4. Circuit selon l'une des revendications précédentes, **caractérisé en ce que** le signal de commande (17) est un signal rectangulaire, en particulier un signal rectangulaire avec un taux d'impulsions d'environ 70 à 95 % et un niveau de signal d'environ 5 V.

5. Circuit selon l'une des revendications précédentes, **caractérisé en ce qu'**un composant (22) forme la première partie d'un diviseur de tension et l'élément capteur (12) la deuxième partie du diviseur de tension, sachant en particulier que le composant (22) qui forme la première partie du diviseur de tension est contenu dans l'unité de captage (14).

6. Circuit selon l'une des revendications précédentes, **caractérisé en ce que** les dispositifs de commutation sont conçus pour le court-circuitage d'une phase du signal de commande (17) appliqué à l'élément capteur (12) sur une tension nulle, sachant que les dispositifs de commutation contiennent de préférence un commutateur (29), en particulier un commutateur avec un composant semi-conducteur.

7. Circuit selon l'une des revendications précédentes, **caractérisé par** un générateur de fréquences (16) pour la production du signal de commande à fréquences modulées (17) avec une fréquence de travail, sachant que, pour la commande des dispositifs de commutation (29), deux composants inverseurs (19, 20) sont de préférence prévus l'un à la suite de l'autre à un endroit quelconque du chemin du signal en aval du générateur de fréquences (16) et en amont de l'élément capteur (12) et sachant que le signal inversé une fois après le premier composant inverseur (19) est à la sortie de ce même composant (19) amené aux dispositifs de commutation (29) et forme la commande de ces derniers.

8. Circuit selon la revendication 2, **caractérisé par** un multiplexeur de signaux (46) avec au moins une entrée (45) pour la connexion d'au moins une sortie (44) d'une unité de captage (14) et avec une sortie à laquelle est connectée une unité d'analyse de signal (48) par l'intermédiaire d'un amplificateur de signaux (47), sachant en particulier que le multiplexeur de signaux (46) est contenu dans l'unité d'analyse (15).

9. Circuit selon l'une des revendications 1 à 6, **caractérisé par** au moins un microcontrôleur (48) conçu au moins pour la production du signal de commande (17) avec une fréquence de travail pour au moins un élément capteur (12), sachant en particulier qu'il contient l'unité de commande (13) et/ou l'unité d'analyse (15) et les dispositifs de commutation (29).

10. Circuit selon l'une des revendications précédentes, **caractérisé en ce que** l'élément capteur (12) est un corps flexible en soi, changeant de forme et conducteur d'électricité, de préférence en matière alvéolaire conductrice d'électricité, sachant qu'il est prévu en particulier pour l'utilisation dans un commutateur tactile d'une plaque de cuisson vitrocéramique ou en verre dur (34).
